# EUROPEAN PATENT APPLICATION

(11) **EP 4 379 751 A1**
(43) Date of publication of application: **05.06.2024**
(21) Application number: 22848682.5
(22) Date of filing: 29.07.2022
(51) Int. Cl.: H01B 13/00

(54) **WIRE HARNESS MANUFACTURING METHOD AND WIRE HARNESS**

(30) Priority: 30.07.2021 CN 202110873848
(71) Applicant: Changchun Jetty Automotive Technology Co., Ltd., Changchun, Jilin 130000 (CN)
(72) Inventor: WANG, Chao, Changchun, Jilin 130000 (CN)
(74) Representative: Boult Wade Tennant LLP
(86) International application number: PCT/CN2022/108998
(87) International publication number: WO 2023/006078

(57) **Abstract**

A wire harness manufacturing method and a wire harness. The method includes: S 110: providing a metal sheet; S120: performing a subtractive process on the metal sheet to make the metal sheet form at least one conductor with a preset conductive trace; and S130: forming an insulation layer on the conductor. The wire harness is manufactured by the wire harness manufacturing method. The present disclosure provides subtractive manufacturing method for manufacturing a wire harness. The manufacturing method is simple, is convenient for manufacturing a complex conductive circuit, and can realize automatic, large-scale rapid production, and achieve high processing speed and precision, thereby greatly reducing the cost of the wire harness and improving the qualification rate thereof.

## Description

### RELATED APPLICATION

The present disclosure claims priority to Chinese Invention Patent Application No. 202110873848.5 filed on July 30, 2021, the disclosure of which is incorporated herein as a part of the present disclosure.

### TECHNICAL FIELD

The present disclosure relates to the technical field of electrical connections, and particularly to a wire harness manufacturing method and the wire harness.

### BACKGROUND

At present, the wire harness used for electrical connection is formed by processing and assembling parts such as an electric wire, a terminal, a sheath, a positioning piece, a bracket, etc., and the manufacturing process is complex. Especially for the wire harness with a small diameter wire, the wire processing is difficult and the processing efficiency is low, which leads to a high production cost, a high defective rate and a low automation degree.

Therefore, the industry of wire harness production urgently needs a wire harness production mode with high production automation degree and low cost.

### SUMMARY

The present disclosure provides a wire harness manufacturing method and a wire harness, so as to solve the problem of low automation degree and high production cost of the wire harness production in the prior art.

Embodiments of a first aspect of the present disclosure provide a wire harness manufacturing method, including: S110: providing a metal sheet; S120: performing a subtractive process on the metal sheet, to make the metal sheet form at least one conductor with a preset conductive trace; and S130: forming an insulation layer on the conductor.

In some embodiments, the wire harness manufacturing method is used to manufacture a wire harness having n layers of conductors, where n is a positive integer greater than 1; the wire harness manufacturing method further includes: Step S100 before Step S110: laying an insulation layer; and Step S140 after Step S130: repeatedly performing Steps S110 to S130 for (n-1) times to obtain a wire harness having n layers of conductors 2. In Step S130 performed each time, the forming an insulation layer on the conductor includes: laying an insulation layer on the conductor formed most recently; and in Step S 110 performed each time, the providing a metal sheet includes: providing a metal sheet on the insulation layer laid most recently.

In some embodiments, the wire harness manufacturing method is used to manufacture a wire harness having n layers of conductors, where n is a positive integer greater than 1; and the wire harness manufacturing method further includes: Step S115 after Step S110 and before Step S120: fixing the metal sheet; and Step S125 after Step S120 and before Step S130: repeatedly performing Steps S110 to S120 for (n-1) times to form n layers of conductors 2. Step S115 performed each time includes: reserving an insulation gap between the metal sheet fixed currently and the metal sheet fixed most recently; and in Step S130, the forming an insulation layer on the conductor includes: forming an insulation layer on surfaces of all conductors and in all insulation gaps.

In some embodiments, in Step S110, the metal sheet provided has a preset shape, and the preset shape is a planar shape or a curved shape.

In some embodiments, the preset shape is a curved shape, and the metal sheet of the curved shape is shaped by forging, rolling, bending, stamping, extruding or integral casting.

In some embodiments, the wire harness manufacturing method further includes: Step S127 after Step S125 and before Step S130: electrically connecting predetermined different layers of conductors among the n layers of conductors by welding or crimping.

In some embodiments, the wire harness manufacturing method further includes: Step S150 after Step S130: electrically connecting predetermined different layers of conductors among the n layers of conductors by punching a hole in the insulation layer and pouring a conductive material into the hole.

In some embodiments, the wire harness manufacturing method further includes: Step S150 after Step S140: electrically connecting predetermined different layers of conductors among the n layers of conductors by punching a hole in the insulation layer and pouring a conductive material into the hole.

In some embodiments, the wire harness manufacturing method further includes: Step S160: rolling the wire harness into a tubular structure around a center line.

In some embodiments, the wire harness manufacturing method further includes: Step S155 before Step S160: disposing a cooling pipe at the center line.

In some embodiments, the wire harness manufacturing method further includes: Step S170: punching a hole in the insulation layer and inserting a conductive terminal into the hole, with one end of the conductive terminal being extended into the insulation layer and being electrically connected to a designated conductor, and the other end of the conductive terminal being located outside an outermost insulation layer.

In some embodiments, in Step S120, the at least one conductor being a plurality of conductors insulated from each other.

In some embodiments, in Step S120, the subtractive process includes: removing a to-be-removed area of the metal sheet by ablation using laser or plasma arc.

In some embodiments, in Step S120, the performing a subtractive process on the metal sheet includes: performing a subtractive process on the metal sheet in an environment of nitrogen or inert gas.

In some embodiments, in Step S130, a process for forming the insulation layer is one or more selected from a coating process, a spraying process, an immersion plating process, an injection molding process and a plastic dipping process.

In some embodiments, Step S120 includes: after forming the at least one conductor with the preset conductive trace, cleaning and drying the conductor.

Embodiments of a second aspect of the present disclosure provide a wire harness, which is manufactured by the wire harness manufacturing method of the embodiments of the first aspect.

In some embodiments, the metal sheet is a rigid metal sheet.

In some embodiments, the metal sheet is a flexible metal sheet.

In some embodiments, a material of the metal sheet includes one or more selected from the group consisting of nickel or an alloy thereof, cadmium or an alloy thereof, zirconium or an alloy thereof, chromium or an alloy thereof, cobalt or an alloy thereof, manganese or an alloy thereof, aluminum or an alloy thereof, tin or an alloy thereof, titanium or an alloy thereof, zinc or an alloy thereof, copper or an alloy thereof, silver or an alloy thereof, and gold or an alloy thereof.

In some embodiments, the metal sheet has a thickness of 0.03 mm to 68 mm.

In some embodiments, a material of the insulation layer comprises one or more selected from the group consisting of polyvinyl chloride, polyurethane, nylon, polypropylene, silicone rubber, crosslinked polyolefin, synthetic rubber, polyurethane elastomer, crosslinked polyethylene and polyethylene.

In some embodiments, the insulation layer has a breakdown strength of 0.3 KV/mm to 35 KV/mm.

In some embodiments, the insulation layer has a thickness of 0.03 mm to 5 mm.

In some embodiments, the wire harness is a signal line.

The wire harness manufacturing method and the wire harness have the following characteristics and advantages:
1. The present disclosure provides a subtractive manufacturing method for manufacturing a wire harness, in which the unneeded part of a metal sheet is removed, leaving the remaining part as the needed conductor, and then an insulating protective layer is formed on an outer side of the conductor to obtain a wire harness. The manufacturing method is simple, is convenient for manufacturing a complex conductive circuit, and can realize automatic, large-scale rapid production, and achieve high processing speed and precision, thereby greatly reducing the cost of the wire harness and improving the qualification rate thereof.
2. In the present disclosure, the insulation layer and the conductor may be alternatively manufactured layer by layer, so as to obtain a wire harness having a plurality of insulation layers and a plurality of layers of conductors that are alternatively disposed. The manufacturing method is simple and high efficiency, and the manufacturing cost of the complex wire harness is reduced.
3. In the present disclosure, a plurality of layers of conductors may be manufactured firstly, and then an insulation layer may be integrally formed outside the plurality of layers of conductors, so as to obtain a wire harness having a plurality of insulation layers and a plurality of layers of conductors that are alternatively disposed. The manufacturing method is simple and high efficiency, and the manufacturing cost of the complex wire harness is reduced.
4. In the present disclosure, by electrically connecting the conductors of different layers, the design scheme of the electrical circuit is optimized and a wire harness with a more complex electrical circuit can be manufactured.
5. In the present disclosure, a subtractive process may be performed on the metal sheet in an environment of nitrogen or inert gas, so as to prevent the oxidization of the metal sheet, and improve the quality and the qualification rate of the wire harness.
6. In the present disclosure, the wire harness having a plurality of layers of conductors may be rolled into a tubular structure to reduce the space occupied by the wire harness during assembly. When being mounted in a groove or a corner position rather than a flat position, the wire harness can be conveniently arranged by being rolled into a tubular structure.
7. In the present disclosure, a cooling pipe may be disposed at the center line of the wound wire harness, and flowing cold air or cooling liquid can be introduced into the cooling pipe for the heat dissipation of the wire harness.
8. In the present disclosure, an electrical branch can be led out by inserting a conductive terminal into the wound wire harness.

### BRIEF DESCRIPTION OF DRAWINGS

The following drawings are only for schematic illustration and explanation of the present disclosure, rather than limiting the scope of the present disclosure. In the drawings,
FIG. 1 illustrates a flow chart of a wire harness manufacturing method according to a first embodiment of the present disclosure;
FIG. 2 illustrates a flow chart of a wire harness manufacturing method according to a second embodiment of the present disclosure;
FIG. 3 illustrates a flow chart of a wire harness manufacturing method according to a third embodiment of the present disclosure;
FIG. 4 illustrates a schematic diagram of performing a subtractive process on a metal sheet using laser or a plasma arc gun;
FIG. 5 illustrates a structural diagram of a wire harness according to a first embodiment of the present disclosure;
FIG. 6 illustrates a structural diagram of a wire harness according to a second embodiment of the present disclosure;
FIG. 7 illustrates a structural diagram of a wire harness according to a third embodiment of the present disclosure;
FIG. 8 illustrates a partially enlarged view at position A in FIG. 7;
FIG. 9 illustrates a structural diagram of a wire harness according to a fourth embodiment of the present disclosure;
FIG. 10 illustrates a partially enlarged view at position B in FIG. 9; and
FIG. 11 illustrates a structural diagram of a wire harness according to a fifth embodiment of the present disclosure.

### DETAILED DESCRIPTION OF EMBODIMENTS

For a clearer understanding of the technical features, objectives and effects of the present disclosure, specific embodiments of the present disclosure will now be described with reference to the drawings. In the description of the present disclosure, unless otherwise specified, `a plurality of' means two or more. In the description of the present disclosure, unless otherwise specified, 'connection' should be understood in a broad sense, and for example, the connection may be a fixed connection, a detachable connection, a direct connection, or an indirect connection through an intermediate medium. Those skilled in the art can understand the specific meanings of the above terms based on specific circumstances.

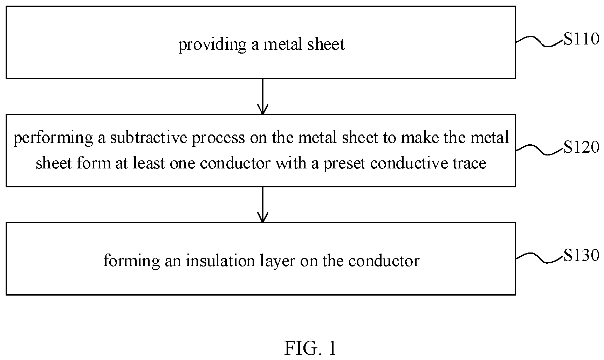

Embodiments of a first aspect of the present disclosure provide a wire harness manufacturing method, as illustrated in FIGS. 1, 4 and 5, the method includes:
Step S110: providing a metal sheet 1;
Step S120: performing a subtractive process on the metal sheet 1 to make the metal sheet 1 form at least one conductor 2 with a preset conductive trace; the preset conductive trace may be a conductive trace with any course and can be configured according to actual needs; and
Step S130: forming an insulation layer 3 on the conductor 2 to wrap the conductor 2.

The present disclosure provides a subtractive manufacturing method for manufacturing a wire harness, in which the unneeded part of a metal sheet is removed, leaving the remaining part as the needed conductor, and then an insulating protective layer is formed on an outer side of the conductor to obtain a wire harness. The manufacturing method is simple, is convenient for manufacturing a complex conductive loop, and can realize automatic, large-scale rapid production, and achieve high processing speed and precision, thereby greatly reducing the cost of the wire harness and improving the qualification rate thereof.

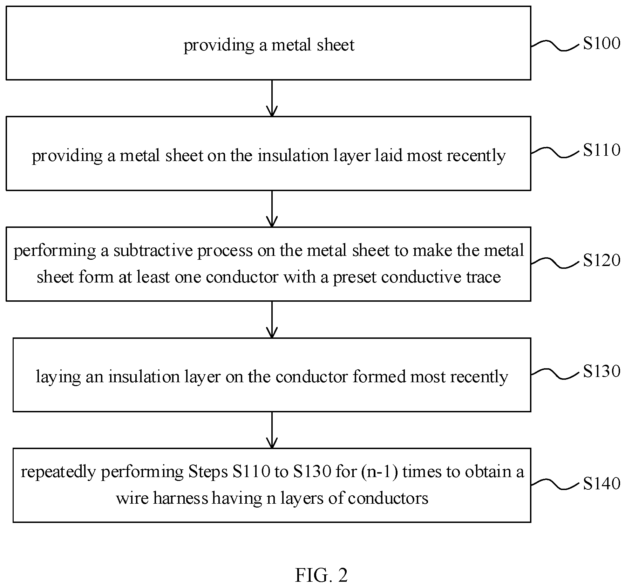

In the first embodiment, as illustrated in FIGS. 2, 6, 7 and 8, the method is used to manufacture a wire harness having n layers of conductors 2, where n is a positive integer greater than 1, and the method further includes:
Step S100 before Step S110: laying an insulation layer 3; and
Step S140 after Step S130: repeatedly performing steps S110 to S130 for (n-1) times to obtain a wire harness having n layers of conductors 2.

In this embodiment, in Step S130 performed each time, the forming an insulation layer 3 on the conductor 2 includes: laying an insulation layer 3 on the conductor 2 formed most recently; in Step S110 performed each time, the providing a metal sheet 1 includes: providing a metal sheet 1 on the insulation layer 3 laid most recently. That is, the insulation layer 3 and the conductor 2 are alternatively manufactured layer by layer, so as to obtain a wire harness having a plurality of insulation layers 3 and a plurality of layers of conductors 2 that are alternatively disposed. The manufacturing method is simple, high-efficiency, and can reduce the cost for manufacturing a complex wire harness.

In this embodiment, the metal sheet 1 may be a rigid metal sheet or a flexible metal foil. The flexible metal foil has a small thickness, generally 0.05 mm to 1 mm, which is especially suitable for manufacturing a wire harness with a small diameter conductor (e.g., a signal lines), thereby solving the problem that it is difficult to manufacture a wire harness with a small diameter conductor.

In this embodiment, further, the metal sheet 1 provided in Step S110 has a preset shape, which may be a planar shape or a curved shape (three-dimensional shape). When the metal sheet is a rigid metal sheet, it needs to be shaped in advance, and then the shaped metal sheet is placed on the insulation layer. For example, the metal sheet may be shaped by forging, rolling, bending, stamping, extruding or integral casting. When the metal sheet is a flexible metal foil, the insulation layer may be made to have a preset shape, e.g., the insulation layer may be made to have a surface of planar or curved shape, and then the flexible metal foil is placed on the surface of the insulation layer, so that the flexible metal foil is naturally attached to the surface of the insulation layer, and the shape of the flexible metal foil is also consistent with that of the surface of the insulation layer.

In this embodiment, the method further includes the following step for electrical connection:
Step S150 after Step S140: electrically connecting predetermined different layers of conductors 2 among the n layers of conductors 2 by punching a hole in the insulation layer 3 and pouring a conductive material 4 into the hole. That is, after the plurality of insulation layers 3 and the plurality of layers of conductors 2 alternatively disposed are obtained, a hole is punched in the insulation layer 3 and poured with a conductive material 4, so as to electrically connect the predetermined different layers of conductors 2.

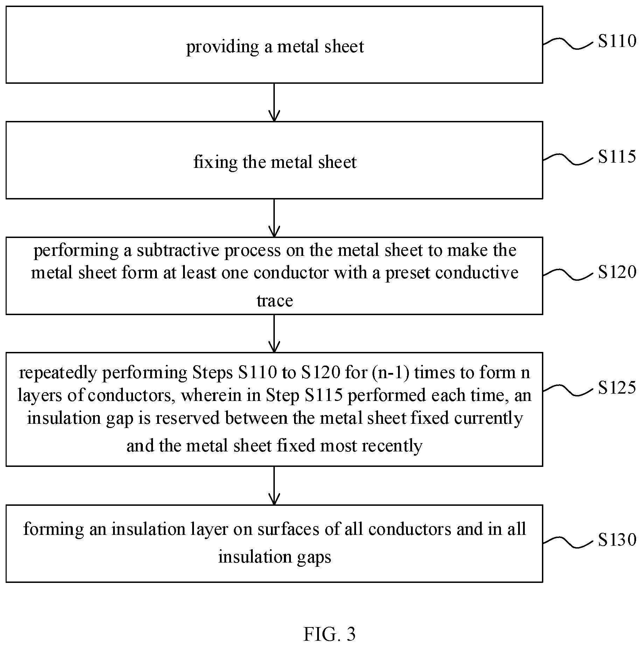

In a second embodiment, as illustrated in FIGS. 3, 6, 7 and 8, the method is used to manufacture a wire harness having n layers of conductors 2, where n is a positive integer greater than 1, and the wire harness manufacturing method further includes:
Step S115 after Step S110 and before Step S120: fixing the metal sheet 1, e.g., clamping the metal sheet 1 for fixation using a clamping member such as a gripper; and
Step S125 after Step S120 and before Step S130: repeatedly performing Steps S110 to S120 for (n-1) times to form n layers of conductors 2.

In this embodiment, Step S115 performed each time includes: reserving an insulation gap between the metal sheet 1 fixed currently and the metal sheet 1 fixed most recently; in Step S130, the forming an insulation layer 3 on the conductor 2 includes: forming an insulation layer 3 on surfaces of all conductors 2 and in all insulation gaps. That is, a plurality of layers of conductors 2 are manufactured firstly, and then an insulation layer 3 (or called an insulator) is integrally formed on the plurality of layers of conductors 2, so as to obtain a wire harness having a plurality of insulation layers 3 and a plurality of layers of conductors 2 that are alternatively disposed. The manufacturing method is simple, is high-efficiency, and can reduce the cost for manufacturing a complex wire harness.

In this embodiment, the metal sheet 1 is exemplarily a rigid metal sheet, because the rigid metal sheet has good rigidity and is easy to be fixed, while the flexible metal foil has a small thickness and is relatively not easy to be fixed without the support of the insulation layer, so that the flexible metal foil is more suitable to be used in the method of the first embodiment for manufacturing a wire harness.

In this embodiment, further, the metal sheet 1 provided in Step S110 has a preset shape, which is a planar shape or a curved shape (three-dimensional shape). For example, the metal sheet may be shaped by forging, rolling, bending, stamping, extruding or integral casting, and then the shaped metal sheet may be fixed.

Forging refers to a processing method which uses a forging machine to exert a pressure on a metal blank to make it be plastically deformed, so as to obtain a forging with certain mechanical properties, certain shape and certain size. Forging is mainly used to process rigid metal plates with a large thickness.

Rolling refers to a mechanical process in which a rolled piece is deformed between rollers. Rolling is mainly used to process planar shapes and simple curved surfaces.

Bending refers to a processing method in which a metal plate is firstly elastically deformed and then plastically deformed under a pressure of an upper die or a lower die of a bending machine. Bending is mainly used to linearly bend a three-dimensional shape.

Stamping refers to a shaping processing method which applies an external force to a plate, a strip, a pipe or a profile by means of a press machine and a die to make it be plastically deformed or separate, so as to obtain a workpiece (stamped piece) with required shape and size. Stamping is mainly used to process rigid metal plates with small thicknesses and complex shapes.

Extrusion refers to a pressure processing method which uses a punch or a convex die to pressurize a blank placed in a concave die to make the blank plastically flow, so as to obtain a workpiece with a shape consistent with the shape of a shape hole of a die or the shape of concave and convex dies of a die.

Integral casting refers to a method of casting liquid metal into a casting cavity with a shape being adaptive to the shape of a part, so as to obtain the part in one go after the liquid metal is cooled and solidified.

In this embodiment, if the conductors of different layers need to be electrically connected, there are two solutions as follows.

In a feasible technical solution, the wire harness manufacturing method includes:
Step S127 after Step S125 and before Step S130: electrically connecting predetermined different layers of conductors among the n layers of conductors by welding or crimping. That is, the predetermined different layers of conductors are electrically connected before the insulation layer is formed, and then an insulation layer is manufactured outside all the conductors. The conductor connecting method in this solution is simple and easy to operate.

In another feasible technical solution, the wire harness manufacturing method includes:
Step S150 after Step S130: electrically connecting predetermined different layers of conductors 2 among the n layers of conductors 2 by punching a hole in the insulation layer 3 and pouring a conductive material 4 into the hole. That is, an insulation layer 3 is firstly manufactured outside all the conductors 2, and then a hole is punched in the insulation layer 3 and poured with a conductive material 4, so as to electrically connect the predetermined different layers of conductors 2.

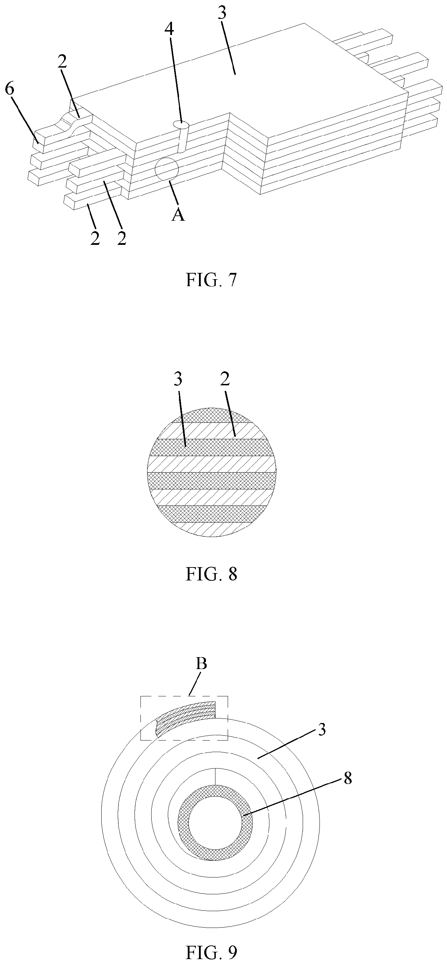

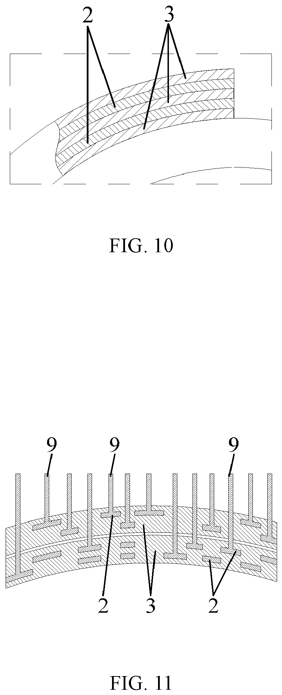

In an embodiment, the wire harness manufacturing method includes:
Step S160: after the wire harness with n layers of conductors 2 is obtained, rolling the wire harness into a tubular structure around a center line (as illustrated in FIGS. 9 and 10) to reduce the space occupied by the wire harness during assembly. When the wire harness is to be mounted in a groove or a corner position rather than a flat position, it is convenient to arrange the wire harness by rolling it into a tubular structure. After being rolled into a tubular structure, the wire harness may also be bent according to the shape of the mounting position thereof.

Further, the method includes Step S155 before Step S160: disposing a cooling pipe 8 at the center line of the wire harness, so that when the wire harness works, flowing cold air or cooling liquid can be introduced into the cooling pipe 8 for heat dissipation of the wire harness.

However, the present application does not limit the mounting time of the cooling pipe 8. The wire harness may be rolled around the cooling pipe 8 into a tubular structure. Alternatively, the wire harness may be rolled into a tubular structure firstly with a central hole reserved at the center line, and then the cooling pipe 8 is inserted into the central hole.

Further, the wire harness manufacturing method includes:
Step S170: punching a hole in the insulation layer 3 and inserting a conductive terminal 9 into the hole (as illustrated in FIG. 11), with one end of the conductive terminal 9 being extended into the insulation layer 3 and being electrically connected to a designated conductor 2, and the other end of the conductive terminal 9 being located outside an outermost insulation layer 3 to lead out an electrical branch. The electrical connection between the conductive terminal 9 and the designated conductor 2 may be a plug-in contact connection or welding, and the conductive terminal 9 may be a male terminal, or a female terminal with a slot.

In an embodiment, in Step S120, the at least one conductor being a plurality of conductors which are insulated from each other, that is, each layer of conductors includes a plurality of conductors which are insulated from each other, thereby obtaining a wire harness with a simple structure and a complicated conductive circuit.

However, the present disclosure is not limited thereto. In other embodiments, each layer of conductors may include only one conductor, or some of the plurality of conductors in each layer of conductors may be electrically connected, all of which can be set according to actual needs.

In an embodiment, in Step S120, the method of subtractive process includes: removing a to-be-removed area of the metal sheet by ablation using laser or plasma arc. For example, the ablation width of laser or plasma arc is 0.03 mm to 5 mm.

Specifically, the to-be-removed area of the metal sheet 1 is ablated by laser or a plasma arc gun 5. The laser or the plasma arc gun 5 may be driven by a three-dimensional servo mechanism, through which the moving path of the laser or the plasma arc gun 5 may be programmed to process conductors of different circuits, which achieves a high flexible production degree and is suitable for flexible production with many models and small batches.

However, the present disclosure is not limited thereto. In other embodiments, the method of subtractive process may also be mechanical cutting, die cutting, etc.

In an embodiment, in Step S120, the subtractive process is performed on the metal sheet in an environment of nitrogen or inert gas, so as to prevent oxidization of the metal sheet.

In an embodiment, a process for forming or laying an insulation layer is one or more selected from a coating process, a spraying process, an immersion plating process, an injection molding process and a plastic dipping process.

In an embodiment, the insulation layer 3 is made of one or more selected from the group consisting of polyvinyl chloride, polyurethane, nylon, polypropylene, silicone rubber, crosslinked polyolefin, synthetic rubber, polyurethane elastomer, crosslinked polyethylene and polyethylene.

In an embodiment, Step S 120 further includes: after forming the at least one conductor with the preset conductive trace, cleaning and drying the conductor, and then forming an insulation layer on the conductor.

Specifically, the copper foil may be cleaned by one or more selected from solution cleaning, ultrasonic cleaning, and high-pressure washing; and the copper foil may be dried by one or more selected from natural drying, cold and hot air drying, and infrared radiation drying.

Natural drying is a method of drying a part using solar radiation energy, hot air, etc. under natural conditions. Natural drying has the characteristics of long drying time and large occupied area, but it does not require any device or power.

Cold and hot air drying is a method of, using cold and hot air as a drying medium, forcing the drying medium to exchange heat and moisture with a part by convection circulation, so as to take away the moisture on the surface of the material. Cold and hot air drying has the characteristics of long drying time and generally low efficiency.

Infrared radiation drying, also known as radiation drying, refers to a drying method of vaporizing moisture on a part by infrared radiation. Infrared radiation drying has the characteristics of high drying speed, but it requires an energy consumption.

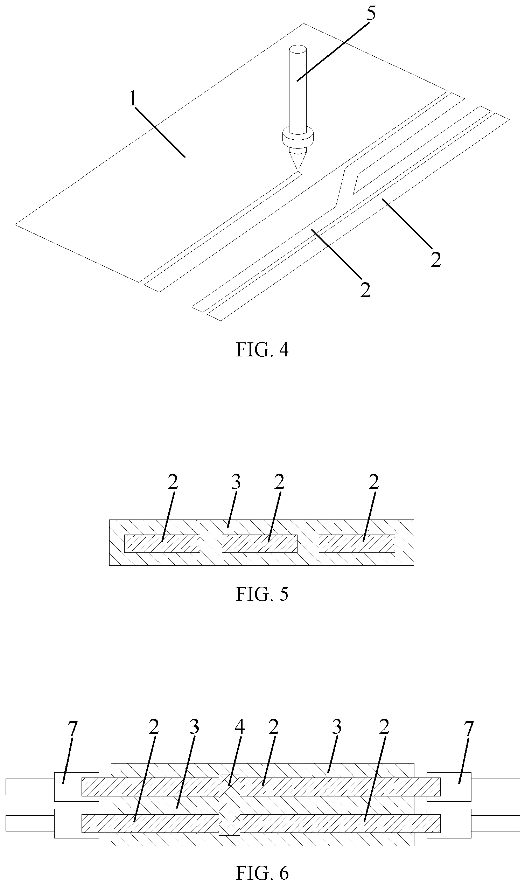

As illustrated in FIGS. 5 to 7, embodiments of a second aspect of the present disclosure provide a wire harness, which is manufactured by the wire harness manufacturing method of the embodiments of the first aspect. The advantageous effects of the wire harness of the embodiments of the second aspect are the same as those of the method of the embodiments of the first aspect, and will not be repeated herein.

In an embodiment, the metal sheet 1 is a rigid metal sheet which has good rigidity and is easy to be fixed. The metal sheet may be shaped by forging, rolling, bending, stamping, extruding or integral casting, and then the shaped metal sheet may be fixed.

In an embodiment, the metal sheet 1 is a flexible metal sheet. The flexible metal sheet may be a thin metal plate or a metal foil, which may be easily deformed and cam be used in some wire harnesses with low requirements for current but with complicated shapes.

In an embodiment, a material of the metal sheet 1 includes one or more selected from the group consisting of nickel or an alloy thereof, cadmium or an alloy thereof, zirconium or an alloy thereof, chromium or an alloy thereof, cobalt or an alloy thereof, manganese or an alloy thereof, aluminum or an alloy thereof, tin or an alloy thereof, titanium or an alloy thereof, zinc or an alloy thereof, copper or an alloy thereof, silver or an alloy thereof, and gold or an alloy thereof. The most commonly used metal material for the conductor is copper or a copper alloy, because copper has good conductivity among various metals and is not a precious metal, and meanwhile, copper has good ductility and is convenient to be processed. However, with the increasing price of copper, the cost of using copper as the material of the conductor will be higher and higher. To this end, people begin to look for alternatives to copper to reduce the cost. The content of aluminum in the earth's crust is about 7.73%, and the price of aluminum is low due to the optimization of its refining technology. In addition, compared with copper, aluminum is lighter and its conductivity is only inferior to copper. Therefore, aluminum or aluminum alloy can replace part of copper or copper alloy in the field of electrical connection.

In an embodiment, the metal sheet 1 has a thickness of 0.03 mm to 68 mm. In the wire harness, the cross-sectional area of the conductor determines the current that the conductor can conduct. Generally, a conductor for signal conduction is able to conduct a small current and has a small cross-sectional area. For example, a conductor of a signal wire in an automotive wire harness may have a minimum cross-sectional area of 0.1 mm². However, a conductor for power conduction is able to conduct a large current and has a large cross-sectional area. For example, a conductor of a wire harness of an automobile battery may have a maximum cross-sectional area of 260 mm².

When the thickness of the metal sheet 1 is less than 0.03 mm, in order to obtain a conductor with a cross-sectional area of 0.1 mm², a conductor with a width of at least 3.3 mm needs to be cut out. Since the width increases as the thickness decreases, the strength of the conductor cannot meet the requirement, and the layout of the wire harness is also restricted, resulting in a failure to reduce the area of the wire harness.

When the thickness of the metal sheet 1 is greater than 68 mm, in order to obtain a conductor with a cross-sectional area of 260 mm², a conductor with a width of at least 3.8 mm needs to be cut out. The width decreases as the thickness increases, but the thickness increases, which makes it more difficult to cut the metal sheet, and the flatness of the cutting edge also cannot be guaranteed.

Therefore, the inventor chooses the thickness of the metal sheet 1 as 0.03 mm to 68 mm, which ensures that wire-harness conductors with different wire diameters and different conduction currents can be obtained by cutting different widths of the metal sheets 1.

In an embodiment, a material of the insulation layer 3 includes one or more selected from the group consisting of polyvinyl chloride, polyurethane, nylon, polypropylene, silicone rubber, crosslinked polyolefin, synthetic rubber, polyurethane elastomer, crosslinked polyethylene and polyethylene.

In an embodiment, a breakdown strength of the insulation layer 3 is 0.3 KV/mm to 35 KV/mm. The breakdown strength is also called a dielectric breakdown strength, which means a highest electric-field strength that a material can withstand without being damaged (broken down) under the action of an electric field. When the breakdown strength is lower than 0.3 KV/mm, some thin insulation layers may be broken down under a normal voltage, resulting in invalid insulation. When the breakdown strength of the insulation layer is higher than 35 KV/mm, the choice of a material with too high breakdown strength will increase the cost of an integrated wire harness assembly and cause design waste, because the general vehicle environment does not have high voltage greater than 35 KV.

In an embodiment, the insulation layer 3 has a thickness of 0.03 mm to 5 mm. If the thickness of the insulation layer is less than 0.03 mm, it not only cannot ensure that the breakdown voltage of the insulation layer is higher than the working voltage, but also cannot guarantee the wear resistance of the insulation layer, which causes the insulation layer to break after being scraped and abraded for many times with the conductor 2 being exposed, which will lead to a current leakage or a short circuit, resulting in a wire damage and a functional failure. When the thickness of the insulation layer is 5 mm, the breakdown voltage, the insulation resistance and the wear resistance of the insulation layer can meet the requirements. However, if the thickness is greater than 5 mm, the insulation layer will have defects such as air holes and collapse generated in the processing process due to the large thickness of the insulation layer, which degrades the performance of the insulation layer and wastes the material thereof, and increases the processing procedures and time. Therefore, the inventor chooses the thickness of the insulation layer as 0.03 mm to 5 mm.

In an embodiment, the wire harness is a signal line.

As the existing electrical appliances in the field of electrical connection have more and more functions, signal lines also increase and account for more than 80% of the existing wire harness circuit. The signal lines are characterized by small conduction current which does not require large-diameter wires for conduction. At present, the signal lines mainly use small-diameter wires with a cross-sectional area of 0.5m², and begin to use smaller-diameter wires with a cross-sectional area of 0.13 m². The smaller the wire diameter, the higher the requirements for the performance and the production process of the wires, and the higher the cost, which has become a bottleneck that hinders the application of small-diameter wires in the wiring harness.

By adopting the subtractive process of the present disclosure, the method for manufacturing the signal line is very simple and high efficient, with a high manufacturing precision and a low manufacturing cost, which supports the application of small-diameter wires in the wire harness.

In an embodiment, the conductor 2 of the wire harness has a terminal end outside the insulation layer 3. The terminal ends of different layers of conductors 2 may form a connection point 6 (as illustrated in FIG. 7) by crimping or welding. The terminal end may also be connected to other electrical circuits through a terminal 7 (as illustrated in FIG. 6), such as a gold finger, a pin terminal, a welded wire, etc.

In an embodiment, as illustrated in FIGS. 9 and 10, the wire harness is in a wound tubular structure to reduce the space occupied by the wire harness during assembly.

As illustrated in FIG. 9, further, a cooling pipe 8 is disposed in a center around which the wire harness is rolled, so as to improve the heat dissipation performance of the wire harness.

As illustrated in FIG. 11, further, a conductive terminal 9 is inserted into the insulation layer 3 of the wire harness, one end of the conductive terminal 9 is electrically connected to a designated conductor 2, and the other end of the conductive terminal 9 is located outside the outermost insulation layer 3, so as to lead out an electrical branch. The conductive terminal 9 may be a male terminal, or a female terminal with a slot.

Compared with the prior art, the wire harness manufacturing method and the wire harness of the present disclosure have at least the following advantages:
1. By producing a wire harness by subtractive process, it is possible to realize automatic, large-scale and rapid production, and achieve high processing speed and precision, thereby greatly reducing the cost of the wire harness and improving the qualification rate thereof.
2. The metal sheet can form a wire harness that is in a three-dimensional structure, which is suitable for the wire harness assemblies in different environments.
3. By means of subtractive process, conductors with different conduction circuits can be processed with a high degree of flexible production, which is suitable for flexible production with many models and small batches.
4. By means of subtractive process, more circuits can be processed on a metal sheet with a small area to meet the requirements of a larger number of electrical circuits.
5. By electrically connecting the conductors of different layers, the design scheme of the electrical circuit is optimized and can be applied to more complex wire harnesses.
6. During the subtractive process of the metal sheet by ablation, nitrogen or inert gas is used to effectively protect the metal sheet from oxidation.

Those described above are merely illustrative specific embodiments of the present disclosure, rather than limiting the scope of the present disclosure. Any equivalent change or modification made by those skilled in the art without departing from the concept and principle of the present disclosure should fall within the protection scope of the present disclosure. In addition, it should be noted that each constituent part of the present disclosure is not limited to the above overall application, and each technical feature described in the specification of the present disclosure can be used alone or in combination according to actual needs. Therefore, the present disclosure naturally covers other combinations and specific applications related to the inventive points of this case.

## Claims

1. A wire harness manufacturing method, comprising:
S110: providing a metal sheet;
S120: performing a subtractive process on the metal sheet to make the metal sheet form at least one conductor with a preset conductive trace; and
S130: forming an insulation layer on the conductor.

2. The wire harness manufacturing method according to claim 1, wherein the wire harness manufacturing method is used to manufacture a wire harness having n layers of conductors, where n is a positive integer greater than 1; and the wire harness manufacturing method further comprises:
Step S100 before Step S110: laying an insulation layer; and
Step S140 after Step S130: repeatedly performing Steps S110 to S130 for (n-1) times to obtain a wire harness having n layers of conductors;
wherein,
in Step S130 performed each time, the forming an insulation layer on the conductor comprises: laying an insulation layer on the conductor formed most recently; and
in Step S110 performed each time, the providing a metal sheet comprises: providing a metal sheet on the insulation layer laid most recently.

3. The wire harness manufacturing method according to claim 1, wherein the wire harness manufacturing method is used to manufacture a wire harness having n layers of conductors, where n is a positive integer greater than 1; and the wire harness manufacturing method further comprises:
Step S115 after Step S110 and before Step S120: fixing the metal sheet; and
Step S125 after Step S120 and before Step S130: repeatedly performing Steps S110 to S120 for (n-1) times to form n layers of conductors;
wherein,
Step S115 performed each time comprises: reserving an insulation gap between the metal sheet fixed currently and the metal sheet fixed most recently; and
in Step S130, the forming an insulation layer on the conductor comprises: forming an insulation layer on surfaces of all conductors and in all insulation gaps.

4. The wire harness manufacturing method according to any one of claims 1 to 3, wherein in Step S110, the metal sheet provided has a preset shape, and the preset shape is a planar shape or a curved shape.

5. The wire harness manufacturing method according to claim 4, wherein the preset shape is a curved shape, and the metal sheet of the curved shape is shaped by forging, rolling, bending, stamping, extruding or integral casting.

6. The wire harness manufacturing method according to claim 3, further comprising:
Step S127 after Step S125 and before Step S130: electrically connecting predetermined different layers of conductors among the n layers of conductors by welding or crimping.

7. The wire harness manufacturing method according to claim 2 or 3, further comprising:
Step S150 after Step S130: electrically connecting predetermined different layers of conductors among the n layers of conductors by punching a hole in the insulation layer and pouring a conductive material into the hole.

8. The wire harness manufacturing method according to claim 2, further comprising:
Step S150 after Step S140: electrically connecting predetermined different layers of conductors among the n layers of conductors by punching a hole in the insulation layer and pouring a conductive material into the hole.

9. The wire harness manufacturing method according to any one of claims 1 to 3, further comprising:
Step S160: rolling the wire harness into a tubular structure around a center line.

10. The wire harness manufacturing method according to claim 9, further comprising:
Step S155 before Step S160: disposing a cooling pipe at the center line.

11. The wire harness manufacturing method according to any one of claims 1 to 3, further comprising:
Step S170: punching a hole in the insulation layer and inserting a conductive terminal into the hole, with one end of the conductive terminal being extended into the insulation layer and being electrically connected to a designated conductor, and the other end of the conductive terminal being located outside the outermost insulation layer.

12. The wire harness manufacturing method according to any one of claims 1 to 3, wherein in Step S120, the at least one conductor being a plurality of conductors insulated from each other.

13. The wire harness manufacturing method according to any one of claims 1 to 3, wherein in Step S120, the subtractive process comprises: removing a to-be-removed area of the metal sheet by ablation using laser or plasma arc.

14. The wire harness manufacturing method according to any one of claims 1 to 3, wherein in Step S120, the performing a subtractive process on the metal sheet comprises: performing a subtractive process on the metal sheet in an environment of nitrogen or inert gas.

15. The wire harness manufacturing method according to any one of claims 1 to 3, wherein in Step S130, a process for forming the insulation layer is one or more selected from a coating process, a spraying process, an immersion plating process, an injection molding process and a plastic dipping process.

16. The wire harness manufacturing method according to any one of claims 1 to 3, wherein Step S120 comprises: after forming the at least one conductor with the preset conductive trace, cleaning and drying the conductor.

17. A wire harness manufactured by the wire harness manufacturing method according to any one of claims 1 to 16.

18. The wire harness according to claim 17, wherein the metal sheet is a rigid metal sheet.

19. The wire harness according to claim 17, wherein the metal sheet is a flexible metal sheet.

20. The wire harness according to claim 17, wherein a material of the metal sheet comprises one or more selected from the group consisting of nickel or an alloy thereof, cadmium or an alloy thereof, zirconium or an alloy thereof, chromium or an alloy thereof, cobalt or an alloy thereof, manganese or an alloy thereof, aluminum or an alloy thereof, tin or an alloy thereof, titanium or an alloy thereof, zinc or an alloy thereof, copper or an alloy thereof, silver or an alloy thereof, and gold or an alloy thereof.

21. The wire harness according to claim 17, wherein the metal sheet has a thickness of 0.03 mm to 68 mm.

22. The wire harness according to claim 17, wherein a material of the insulation layer comprises one or more selected from the group consisting of polyvinyl chloride, polyurethane, nylon, polypropylene, silicone rubber, crosslinked polyolefin, synthetic rubber, polyurethane elastomer, crosslinked polyethylene and polyethylene.

23. The wire harness according to claim 17, wherein the insulation layer has a breakdown strength of 0.3 KV/mm to 35 KV/mm.

24. The wire harness according to claim 17, wherein the insulation layer has a thickness of 0.03 mm to 5 mm.

25. The wire harness according to claim 17, wherein the wire harness is a signal line.
